# EUROPÄISCHE PATENTSCHRIFT

(11) **EP 3 507 608 B1**
(45) Veröffentlichungstag und Bekanntmachung des Hinweises auf die Patenterteilung: **26.06.2024**
(21) Anmeldenummer: 17761252.0
(22) Anmeldetag: 01.09.2017
(51) Int. Cl.: G01R 29/08

(54) **VORRICHTUNG ZUR DURCHFÜHRUNG VON EMV-TEST-MESSUNGEN**
DEVICE FOR CARRYING OUT EMC TEST MEASUREMENTS
DISPOSITIF POUR EFFECTUER DES MESURES PAR TEST DE COMPATIBILITÉ ÉLECTROMAGNÉTIQUE

(30) Priorität: 01.09.2016 DE 202016104835 U
(43) Veröffentlichungstag der Anmeldung: 10.07.2019
(73) Patentinhaber: Zwerger-Schuster, Anita Silvia, 80995 München (DE)
(72) Erfinder: Zwerger-Schuster, Anita Silvia, 80995 München (DE)
(74) Vertreter: 2s-ip Schramm Schneider Bertagnoll Patent- und Rechtsanwälte Part mbB
(86) Internationale Anmeldenummer: PCT/EP2017/072019
(87) Internationale Veröffentlichungsnummer: WO 2018/042020

(56) Entgegenhaltungen:
- US-A1- 2005 253 762
- US-A1- 2014 184 241
- US-A1- 2015 260 772
- Pontis EMC Products: "EMC Hardened Audio and Video System", , 17. April 2016 (2016-04-17), Seiten 1-8, XP002774321, Gefunden im Internet: URL:http://www.pontis-emc.com/downloads/PO NTIS-EMC-Brochure-2016-04-17-EN-MR.pdf [gefunden am 2017-10-02]

## Beschreibung

### Gebiet der Erfindung

Die Erfindung betrifft eine Vorrichtung zur Durchführung von EMV-Test-Messungen, mit der die elektromagnetische Verträglichkeit eines technischen Geräts geprüft bzw. überprüft werden kann. Das technische Gerät dessen elektromagnetische Verträglichkeit geprüft werden soll, wird nachfolgenden als das "zu prüfende System" bezeichnet.

### Hintergrund der Erfindung

EMV-Test-Messungen werden heute in der Regel in speziellen stationären EMV-Labors durchgeführt. Die Messeinrichtungen sind hier fix außerhalb des EMV-Labors angeordnet. Die Versuchsanordnungen gestalten sich hierbei meist sehr aufwändig, weil das zu prüfende System erst in das EMV-Labor transportiert werden muss und die Messeinrichtungen in dem EMV-Labor manuell korrekt angeordnet werden müssen, was einen erheblichen Zeitaufwand erfordert und zusätzliche Kosten verursacht..

Ferner ist es bekannt, das zu prüfende System in einer Art Messzelle anzuordnen, um die Umgebungseinflüsse auf die Messung zu reduzieren. Die Messgeräte selbst befinden sich außerhalb der Box und müssen bei Bedarf an die Messzelle angeschlossen werden. Als mobile EMV-Labore eignen sich solche Systeme allerdings nicht, weil die Messzelle und die Messgeräte getrennt voneinander transportiert werden müssen. Auch hier müssen das zu prüfende System und die Messeinrichtungen in der Messzelle manuell korrekt relativ zueinander angeordnet werden, was einen erheblichen Zeitaufwand erfordert.

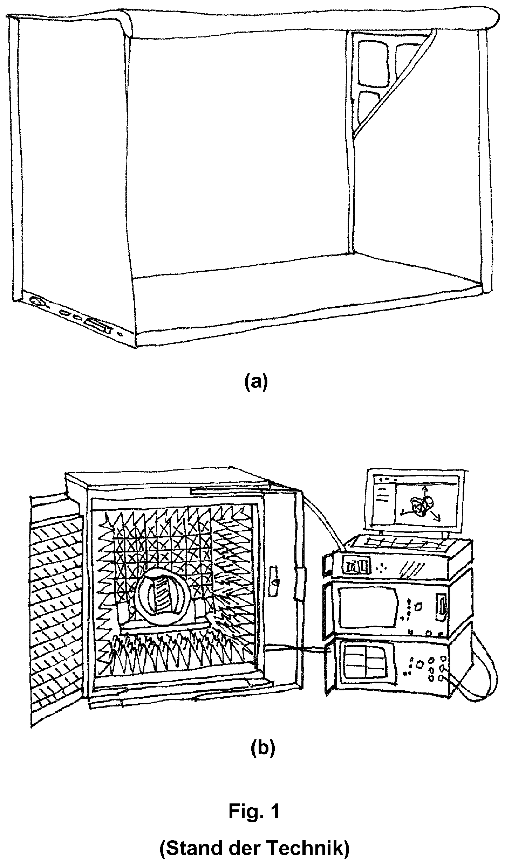

Eine aus dem Stand der Technik bekannte Messzelle ist in **Fig. 1 (a)** gezeigt. Diese Messzelle besteht im Wesentlichen aus einem Schirmzelt. Das Zelt kann an der Seite geöffnet werden. Auch hier müssen die Messgeräte zusätzlich außerhalb der Messzelle angebracht werden.

Eine weitere aus dem Stand der Technik bekannte Messzelle ist in **Fig. 1 (b)** gezeigt. Die Schirmung ist bei den in Fig. 1 (b) gezeigten Messzellen deutlich besser als bei den in Fig. 1 (a) gezeigten Messzellen. Allerdings müssen auch hier die Messgeräte außerhalb der Messzelle angebracht werden.

Aus dem Stand der Technik ist weiterhin die Druckschrift US 2015/260772 A1 bekannt, die ein bewegbares Nahfeldantennen-Messsystem offenbart und eine echofreie Kammer umfasst, die zu Datenerfassung und Mustermessungen in der Lage ist, eine Charakterisierung der drahtlosen Kommunikationsparameter von tragbaren elektronischen Geräten zu ermöglichen. US 2015/260772 A1 offenbart weiterhin ein Kamerasystem innerhalb der echofreien Kammer zum Abbilden eines Miniatur-Antennenchips, um einen elektrischen Kontakt zwischen einer Sonde und einem Antennenchip sicherzustellen. Das Bild wird auf einem Monitor (von einem Computer) außerhalb der echofreien Kammer angezeigt. Die Kammer besteht dabei aus einem einzigen Gehäuse, wobei sich die Prüfgeräte in einem zusätzlichen Gestell außerhalb des Gehäuses befinden. US 2015/260772 A1 offenbart keinen drehbaren Drehteller, sondern eine drehbare ringförmige Platte, auf der eine Messantenne montiert ist. Das DUT ist dabei fixiert und bewegt sich nicht, und die drehbare ringförmige Platte dreht sich während sphärischen Messungen. Damit sind die minimalen Dimensionen (Länge und Breite) der Prüfkammer durch den Durchmesser des drehbaren Rings vorgegeben, somit kann der Abstand zwischen Antenne und Prüfling nicht eingestellt werden. Der minimale Durchmesser des drehbaren Rings ist wiederum durch den minimalen Abstand der Antenne zum Prüfling vorgeben.

Aus dem Stand der Technik ist weiterhin die Druckschrift US 2005/253762 A1 bekannt, die ein mobiles Testlabor für elektromagnetische Verträglichkeit (EMV) offenbart, die ein mobiles Gehäuse, eine Testvorrichtung, eine Abschirmeinheit und ein erstes/zweites Testset umfasst. Das Gehäuse hat eine Oberseite, einen Innenraum und eine Abschirmplatte, die innerhalb des Innenraums eingebaut ist, um den Innenraum in einen ersten Raum und einen zweiten Raum zu unterteilen. Die Testvorrichtung ist im ersten Raum und die Abschirmeinheit ist im zweiten Raum installiert. Das erste Testset, das einen Drehteller und einen Empfänger umfasst, ist im zweiten Raum montiert und in der Abschirmeinheit eingeschlossen. Der Empfänger ist vom Drehteller getrennt und mit der Testvorrichtung im ersten Raum elektrisch verbunden. Die gezeigte Antenne ist fest und unbeweglich installiert. Das mobile Labor kann bequem an jeden gewünschten Ort transportiert werden.

Aus dem Stand der Technik ist weiterhin die Druckschrift US 2014/184241 A1 bekannt, die ein stationäres EMV-Testsystem offenbart, bei dem der Verstärker und der Empfänger innerhalb der EMV-Kammer angeordnet sind, so dass die Länge des Koaxialkabels zum Übertragen von Signalen verkürzt wird, um die Dämpfung der übertragenen Signale zu verringern und die Ausrüstungskosten zu senken. US 2014/184241 A1 zeigt einen Drehtisch auf dem der Prüfling angeordnet wird, und eine Antenne, deren Abstand zum Boden eingestellt werden kann.

Die aus dem Stand der Technik bekannten Messzellen weisen zudem den Nachteil auf, dass nur ganz bestimmte Arten von Messungen durchgeführt werden können, sodass das volle Einsatzspektrum eines EMV-Labor bei weitem nicht erreicht werden kann.

### Aufgabe der Erfindung

Aufgabe der vorliegenden Erfindung ist es daher, die aus dem Stand der Technik bekannten Nachteile zumindest teilweise zu vermeiden und eine Vorrichtung zur Durchführung von EMV-Test-Messungen bereit zu stellen, die einerseits als mobiles EMV-Messsystem verwendet werden kann, ohne dass die Messgerät separat transportiert werden müssen, und die ein wesentlich größeres Einsatzspektrum als herkömmliche Messzellen ermöglicht. Ferner soll die Schirmung dadurch nicht beeinträchtigt werden.

### Erfindungsgemäße Lösung

Erfindungsgemäß wird diese Aufgabe mit einer Vorrichtung zur Durchführung von EMV-Test-Messungen nach dem unabhängigen Anspruch gelöst. Vorteilhaft Ausgestaltungen und Weiterbildungen der Erfindung sind in den abhängigen Ansprüchen angegeben.

Bereit gestellt wird demnach eine Vorrichtung zur Durchführung von EMV-Test-Messungen, wobei die Vorrichtung eine als mobile Box ausgestaltete Messzelle aufweist, wobei
- die Box an einer Seite ein Öffnung aufweist, die zumindest teilweise öffenbar und wieder verschließbar ist, wobei die Öffnung so ausgestaltet ist, dass durch sie hindurch zumindest ein zu prüfendes System in das Innere der Box einbringbar ist,
- das Innere der Box in zwei Bereiche, vorzugsweise in einen oberen Bereich und in einen unteren Bereich, unterteilt ist,
- in einem der beiden Bereiche (Gerätebereich) die Messgeräte anordenbar sind und in dem jeweils anderen Bereich (Messbereich) das zu prüfende System anordenbar ist, und
- die Unterteilung des Inneren der Box in zwei Bereiche durch eine Platte erfolgt, wobei die Platte eine Absorberschicht und/oder eine Dämpfungsschicht und/oder eine Schirmungsschicht aufweist, um Störungen der zu prüfenden Systems durch die Messgeräte und/oder Störungen der Messgeräte durch das zu prüfende System weitgehend zu verhindern, und wobei
- die Öffnung des Messbereichs mit Klappen oder Türen verschließbar ist, wobei die Klappen oder Türen eine Absorberschicht und/oder Dämpfungsschicht und/oder Schirmungsschicht aufweisen,
- in dem Messbereich ein Drehteller, eine EMV-Antenne und Kamerasysteme angeordnet sind, wobei der Drehteller Anschlüsse für das zu prüfende System aufweist und wobei der Drehteller ausgestaltet ist, das zu prüfende System aufzunehmen,
- wobei die EMV-Antenne beweglich und ausrichtbar ausgestaltet ist, wobei
- die EMV-Antenne auf einen fest definierten Abstand zum zu prüfenden System einstellbar ist,
- der Abstand der EMV-Antenne zum Boden des Messbereiches einstellbar ist,
- Drehwinkel der EMV-Antenne um ihre vertikale Achse einstellbar ist, und
- die EMV-Antenne um eine horizontale Achse drehbar ist, und
- an der Außenwandung der Box zumindest eine Anzeigeeinrichtung (60) angeordnet ist, die mit den Komponenten in dem Messbereich und/oder mit den Messgeräten in dem Messbereich koppelbar ist.

Die Platte kann aus einer oder mehreren Teilplatten bestehen. Die Platte bzw. die Teilplatten können Ferritplatten sein. Alternativ können die Platten bzw. die Teilplatten eine Metallplatte, vorzugsweise aus Aluminium, aufweisen, auf der eine Mu-Metallfolie aufgebracht ist und auf der wiederum Ferritplatten angebracht sind.

Damit können sowohl das zu prüfende System als auch die Messgeräte in der Box angeordnet werden. Die Box kann samt der Messgeräte einfach transportiert werden. Die Platte mit der Absorberschicht und/oder Dämpfungsschicht und/oder Schirmungsschicht gewährleistet, dass Störungen des zu prüfenden Systems durch die Messgeräte und/oder Störungen der Messgeräte durch das zu prüfende System weitgehend verhindert werden. Dadurch können die Messgeräte auch während der Messung in der Box verbleiben, sodass ein Anordnen der Messgeräte, wie im Stand der Technik erforderlich, außerhalb der Box entfällt.

Vorteilhaft ist es, wenn neben der Platte, die die Box in zwei Bereiche teilt, auch die Wände (Seitenwände und Decke bzw. obere Wand) des Messbereiches eine Absorberschicht und/oder Dämpfungsschicht und/oder Schirmungsschicht aufweisen.

Damit kann der gesamte Messbereich von der Außenwalt abgeschirmt werden und Störungen des zu prüfenden Systems und unerwünschte Beeinflussungen der Messungen verhindert werden.

In dem Messbereich kann zumindest eines aus der Gruppe umfassend Roboterarm, EMV-Wärmebildkamera, Wärmebildkamera, Sensoren, Mikrofon, Beleuchtung, EMV-Lüfter, und Kombinationen hiervon, anordenbar sein. Diese werden zusammen mit Drehteller, Kamerasystem und EMV-Antenne nachfolgend gemeinsam als "Komponenten" bezeichnet.

Die Messgeräte können lösbar in dem Gerätebereich anordenbar sein, um einen einfachen und schnellen Austausch der Messgeräte zu ermöglichen.

Die in dem Messbereich angeordneten Komponenten können lösbar in dem Messbereich angeordnet sein, um einen einfachen und schnellen Austausch der Komponenten zu ermöglichen.

Damit wird ein vollständig modularer Aufbau der EMV-Messvorrichtung erreicht, sodass die EMV-Messvorrichtung schnell und einfach an unterschiedlichste Versuchsszenarien angepasst werden kann. Insbesondere können bei einem Transport der EMV-Messvorrichtung sowohl die Komponenten als auch die Messgeräte in der EMV-Messvorrichtung verbleiben, was den Transport erheblich vereinfacht. Zudem sind die Komponenten und die Messgeräte so vor Beschädigungen beim Transport geschützt.

Wenn an der Außenwandung der Box, vorzugsweise an der linken und/oder rechten Außenwandung, zumindest eine Anzeigeeinrichtung, vorzugsweise ein oder zwei Flachbildschirme, angeordnet sind, die mit den Komponenten in dem Messbereich und/oder mit den Messgeräten in dem Messbereich operativ koppelbar sind, erfolgt die Koppelung so, dass diese die Messungen nicht beeinflussen, d.h., eventuell notwendige Kabel verlaufen außerhalb der Absorberschicht, Dämpfungsschicht und/oder Schirmungsschicht oder sind entsprechend abgeschirmt.

Die Anzeigeeinrichtung kann lösbar an der Box angeordnet sein und/oder sie kann schwenkbar an der Box angeordnet sein.

Die Messgeräte können ausgewählt sein aus der Gruppe zumindest umfassend Analyser, Oszilloskop, Netzteil, T-Netz Nachbildung, Videorekorder, und Kombinationen hiervon. Weitere verschiedene Messgeräte sind möglich. Aufgrund des modularen Aufbaus der erfindungsgemäßen Vorrichtung können die Messgeräte je nach Bedarf und Anforderung an die durchzuführende Messung ausgetauscht werden.

Vorteilhafterweise ist der Roboterarm so ausgestaltet und so relativ zum Drehteller angeordnet, dass mit ihm zumindest ein Sensor oder zumindest eine Messeinrichtung relativ zum Drehteller bewegt werden kann. Vorteilhafter Weise kann mit dem Roboterarm ein Sensor, etwa ein Nahfeldsensor bzw. eine Nahfeldsonde, an das zu prüfende System herangeführt werden.

Der Roboterarm kann von außerhalb der Box steuerbar sein, etwa mittels eines Joysticks, einer Maus oder einem anderen Eingabegerät.

Die EMV-Antenne in dem Messbereich ist ausrichtbar ausgestaltet, wobei das Ausrichten der EMV-Antennen von innerhalb, vorzugsweise jedoch von außerhalb der Box erfolgt.

Das Kamerasystem kann zumindest eine, vorzugsweise zwei, besonders bevorzugt vier Kameras aufweisen, wobei die Kameras vorzugsweise stationär in den Eckbereichen im Inneren des Messbereiches angeordnet sind.

Das Kamerasystem kann auch zumindest eine Wärmebildkamera umfassen, wobei die Wärmebildkamera relativ zum Drehteller bewegbar in dem Messbereich angeordnet ist. Hierzu kann es vorteilhaft ein, wenn die Wärmebildkamera ein- und ausfahrbar ausgestaltet ist.

An bzw. auf dem Drehteller ist das zu prüfende System anordenbar. Der Drehteller kann von außerhalb der Box steuerbar sein, insbesondere seine Drehrichtung und seine Drehgeschwindigkeit.

Da der Drehteller Anschlüsse für das zu prüfende System aufweist, können etwa Daten des zu prüfenden Systems nach außen übertragen werden oder das zu prüfende System kann von außen gesteuert werden. Bei einem Mobiltelefon als zu prüfendes System kann so beispielsweise die Sendeleistung des Mobiltelefons von außen eingestellt werden. Die Anschlüssen können beispielsweise USB-Anschlüsse oder dergleichen umfassen.

Das sämtliche Komponenten in dem Messbereich und gegebenenfalls auch das zu prüfende System von außerhalb der Box steuerbar sind, kann eine vollautomatische EMV-Prüfung durchgeführt werden, die mehrerer einzelne Prüfschritte umfasst, wobei in jedem Prüfschritte die Anordnung der Sensoren oder Messsysteme relativ zum zu prüfenden System verändert werden kann. Die Box muss hierzu nicht geöffnet werden. Die Steuerung kann mit einem Computer oder Mikrocontroller erfolgen, der ebenfalls in dem Gerätebereich angeordnet sein kann. Ein vollständiger EMV-Test sowie eine Fehleranalyse, etwa mittels der Kameras und/oder der Nahfeldsonde, kann so erheblich schneller durchgeführt werden.

Die Seitenwände der Box können aus einem Metall, insbesondere Aluminium, besonders bevorzugt aus eloxiertem Aluminium bestehen.

In einer Ausgestaltung der Erfindung kann die Box eine maximal Abmessung von 300x240x260, vorzugsweise von 240x140x160, besonders bevorzugt von 140x60x80 (LxBxH in cm) aufweisen. Größere Boxen sind von der Erfindung jedoch ebenfalls umfasst, sofern ihr Gewicht samt der darin aufgenommen Messgeräte sich für den mobilen Einsatz eignet.

### Kurzbeschreibung der Figuren

Einzelheiten und Merkmale, insbesondere vorteilhafte Ausgestaltungen und Weiterbildungen der Erfindung ergeben sich aus der nachfolgenden Beschreibung in Verbindung mit der Zeichnung. Es zeigt:
- Fig. 1: zwei Beispiele einer EMV-Messzelle aus dem Stand der Technik.
- Fig. 2: eine Übersicht einer erfindungsgemäßen EMV-Messvorrichtung;
- Fig. 3: eine erfindungsgemäße EMV-Messvorrichtung im geöffneten Zustand;
- Fig. 4: eine erfindungsgemäße EMV-Messvorrichtung mit einer darin angeordneten EMV-Antenne (in zwei verschiedenen Ausführungsformen und Stellungen);
- Fig. 5: eine erfindungsgemäße EMV-Messvorrichtung mit einem darin angeordneten Roboterarm;
- Fig. 6: eine erfindungsgemäße EMV-Messvorrichtung mit einer darin angeordneten Wärmebildkamera; und
- Fig. 7: eine erfindungsgemäße EMV-Messvorrichtung mit darin angeordneten Videokameras.

### Detaillierte Beschreibung der Erfindung

Bei der Erfindung handelt es sich um eine mobile Vorrichtung (nachfolgend auch Messzelle, EMV-Messzelle oder Box genannt) mit der EMV-Messungen und / oder Fehleranalysen durchgeführt werden können. Die für die Messungen nötigen Messgeräte befinden sich nicht außerhalb der Messzelle, wie im Stand der Technik üblich, sondern sind in die Messzelle, die als Box ausgestaltet ist, integriert. Die Störaussendung (z.B. Störsignale) der Messgeräte führen nicht zur Störung der Messung, da eine Absorber- und/oder eine Schirmungs- und/oder Dämpfungsschicht zwischen dem Messbereich, in dem die Messungen stattfinden, und dem Gerätebereich angebracht ist. Die Absorber- und/oder Schirmungs- und/oder Dämpfungsschicht ist Bestandteil einer Platte, die das Innere der Box in die beiden Bereiche Messbereich und Gerätebereich unterteilt.

Zusätzlich sind an Außenwänden des Messbereiches Absorber- und/oder eine Schirmungs- und/oder Dämpfungsschichten angebracht, sodass auch effektiv gewährleistet ist, dass Störeinflüsse von außerhalb die Messungen nicht beeinflussen.

Mit der erfindungsgemäßen Vorrichtung können alle Arten von EMV-Test-Messungen von der Entwicklungsbegleitung bis zur Fertigung, sowie auch Fehleranalysen durchgeführt werden.

Die erfindungsgemäße Vorrichtung weist gegenüber den aus dem Stand der Technik bekannten Systemen folgende wesentliche Vorteile auf:
1. Alle für die Messungen nötigen Komponenten, wie Mess-, Antriebs- und Steuerungsgeräte sind hier direkt in die Box integriert und nicht separat und/oder außerhalb platziert.
2. Alle Komponenten sind sofort ohne Zusatzaufwand einsatzbereit. Ein zusätzlicher Aufwand für das Anbringen der Komponenten entfällt.
3. Beim Transport werden alle Komponenten nicht einzeln, sondern zusammen, ohne Umbau- oder Abbaumaßnahmen transportiert. Zudem sind die Komponenten so effektiv vor Transportschäden geschützt.
4. Da alle Komponenten in der Box integriert sind, ist ein schneller Auf- und Abbau, sowie Ortswechsel der gesamten Messvorrichtung möglich.
5. Ohne Zusatzaufwand können alle Arten von leitungsgebundenen Messungen durchgeführt werden.
6. Ohne Zusatzaufwand können alle Arten der "Radiated Emission" Messungen (gestrahlte Emissionsmessungen) durchgeführt werden.
7. Bei leitungsgebundener Messung ist eine unmittelbare Fehleranalyse der zu prüfenden Systeme möglich.
8. Magnetische Felder des zu prüfenden Systems können sofort lokalisiert werden (z.B. über eine Wärmebildkamera).

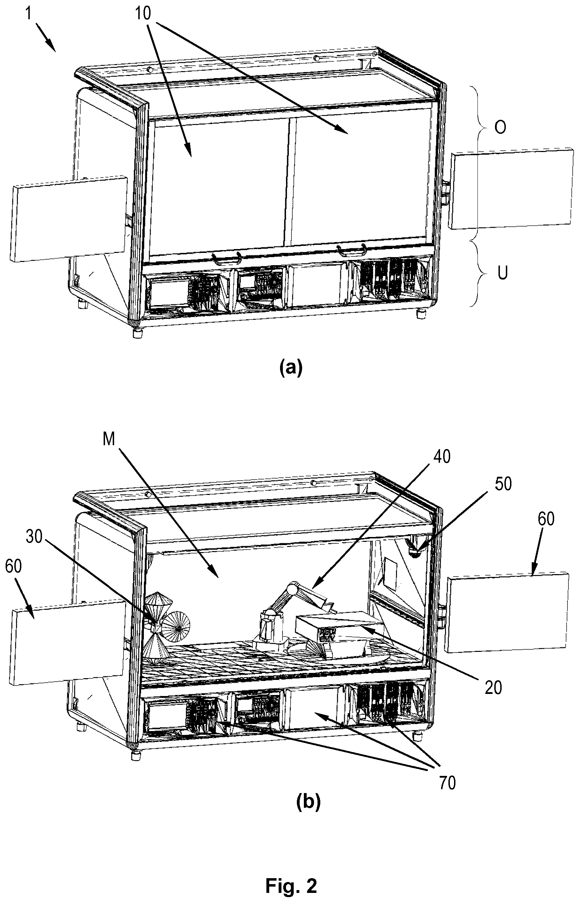

**Fig. 2 (a)** zeige eine erfindungsgemäße Vorrichtung in einem geschlossenen Zustand.

Die Box 1 besteht hier aus einer Metallbox mit einer Länge von 140cm, einer Breite von 60cm und einer Höhe 80cm. Andere Abmessungen sind möglich. Auf der Längsseite befindet sich ein aufschiebbarer Deckel. Anstelle eines aufschiebbaren Deckels kann auch ein schwenkbarer Deckel oder zwei schwenkbare Türen / Deckel vorgesehen sein.

Die Box ist in zwei Teile bzw. Bereiche eingeteilt, wie aus **Fig. 2 (b)****,** in der die erfindungsgemäße Vorrichtung im geöffneten Zustand gezeigt ist, erkennbar ist. Im unteren Bereich U, der hier 140cm lang und 20cm hoch ist, befinden sich die Messgeräte 70, die Antriebe und die Steuerung. Im oberen Bereich O befindet sich die eigentliche Messkammer (M) mit Drehteller 20, Antenne 30, Roboterarm 40, Kameras 50, Beleuchtung (hier nicht gezeigt) und Mikrofon (hier nicht gezeigt). Die Kameras können Überwachungskameras und Wärmebildkameras 55 umfassen.

Der obere Bereich O der Messzelle und der untere Bereich U der Messzelle sind durch eine Absorberschicht und/oder Dämpfungsschicht und/oder Schirmung abgeteilt, sodass die Störungen der Geräte keinen Einfluss auf die Messergebnisse der zu prüfenden Systeme haben. Diese Absorberschicht und/oder Dämpfungsschicht und/oder Schirmung kann durch eine Metallplatte gebildet werden, auf der eine beispielsweise 60 mm dicke Ferritfliesenschicht angebracht ist. Alternativ kann auf einer Metallplatte eine Mu-Metallfolie angebracht werden, auf der wieder Ferritfliesen angeordnet sind. Diese Absorberschicht und/oder Dämpfungsschicht und/oder Schirmung kann auch mehreren Segmenten gebildet werden.

Die Wände (Seitenwände und Decke bzw. obere Wand) des oberen Bereiches O (Messbereich) und die Deckel bzw. Türen 10 weisen ebenfalls eine Absorberschicht und/oder Dämpfungsschicht und/oder Schirmungsschicht auf, sodass der Innenraum des oberen Bereichs O vollständig von der Außenwelt abgeschirmt ist und Störungen des zu prüfenden Systems effektiv verhindert werden. Hierzu kann an den Innenwänden und an der Decke eine Abschirmungsfolie und eine Mu-Metallfolie als EMV-Folie angebracht werden, auf der eine Absorberschicht aufgebracht wird. Als Absorberschicht kann ein Polyurethan-Schaum verwendet werden, der vorzugsweise einen Frequenzbereich von etwa 30 MHz bis 10 GHz abdeckt. Alternativ können die Wände so abgeschirmt werden wie die der obere Bereich O der Messzelle von dem unteren Bereich U der Messzelle.

An den Seiten der Messzelle sind zwei Halterungen für Bildschirme 60 angebracht, mit denen die Messungen und der Prüfaufbau dargestellt werden.

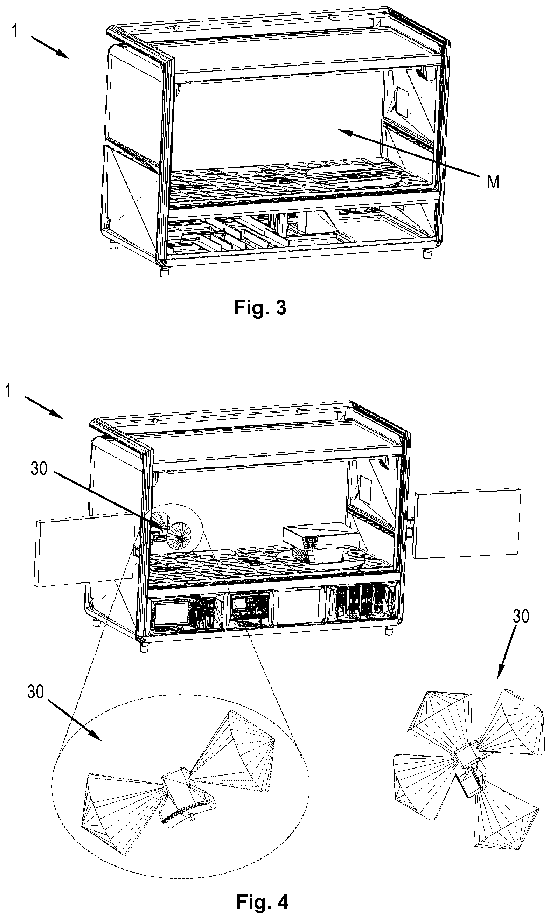

**Fig. 3** zeigt eine erfindungsgemäße Box 1 in einem geöffneten Zustand, in der noch keine Messgeräte angeordnet sind. Erkennbar sind hier die im unteren Bereich U vorgesehenen Einschübe für die Messgeräte 70. Die Gehäusebox ist hier aus einem Aluminiumrahmen gefertigt. Die Seitenteile und die Türen 10 sind hier aus pulverbeschichtetem Aluminiumblech.

**Fig. 4** zeigt die erfindungsgemäße Vorrichtung 1 mit im unteren Bereich U angeordneten Messgeräten 70 und mit einem im oberen Bereich O angeordneten Drehteller 20 und einer EMV-Antenne 30. Die EMV-Antenne ist in zwei verschiedenen Ausgestaltungen in einer vergrößerten Ansicht gezeigt. Die EMV-Antenne 30 kann bewegbar ausgestaltet sein.

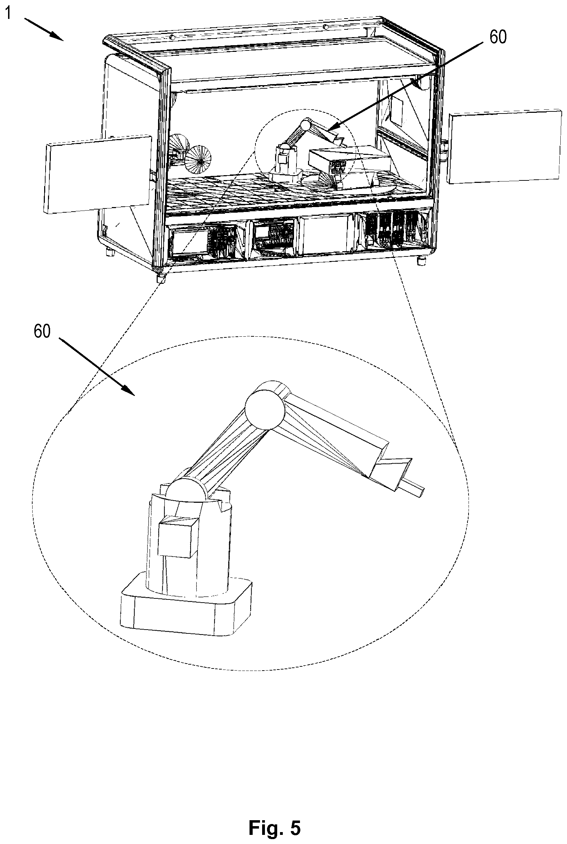

Gemäß **Fig. 5** ist in dem oberen Bereich O zusätzlich ein Roboterarm 40 angeordnet, der zusätzlich in einer vergrößerten Ansicht dargestellt ist.

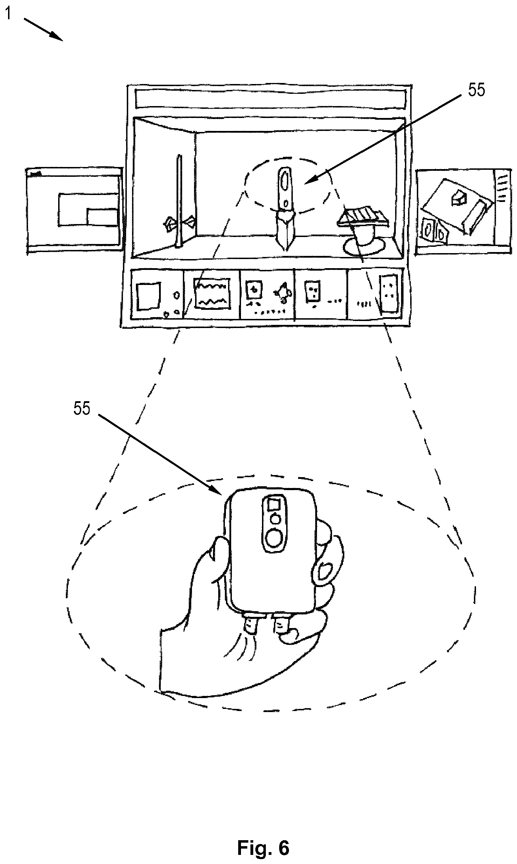

Gemäß **Fig. 6** ist in dem oberen Bereich O eine Wärmebildkamera 55 angeordnet. Zusätzlich kann auch hier ein Roboterarm 40 angeordnet sein, der hier allerdings nicht gezeigt ist, und/oder weitere Komponenten angeordnet sein.

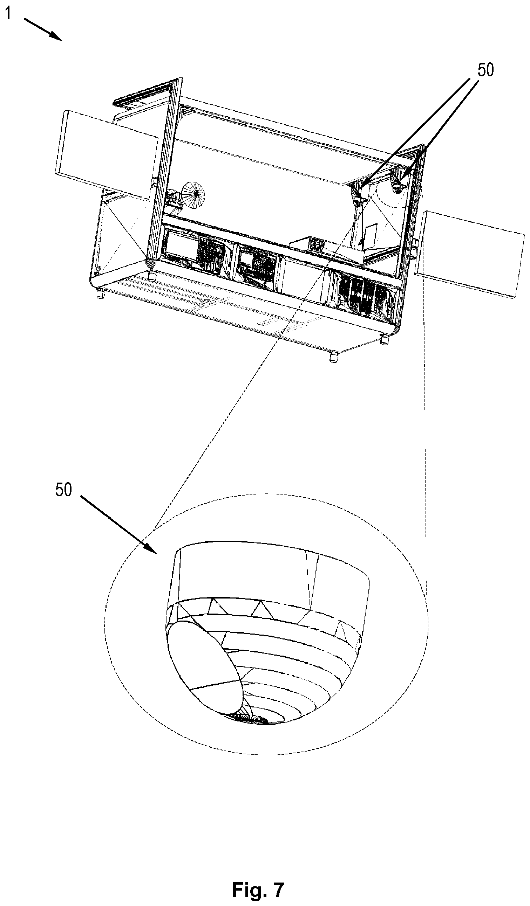

Gemäß **Fig. 7** sind in dem oberen Bereich O vier Kameras 50 (in jeder oberen Ecke eine), vorzugsweise Videokameras angeordnet, wobei hier nur die beiden recht Kameras 50 zu sehen sind. Zusätzlich können auch hier noch ein Roboterarm und/oder eine Wärmebildkamera und/oder weitere Komponenten angeordnet sein.

Die einzelnen Komponenten der erfindungsgemäßen Vorrichtung 1 werden nachfolgend detaillierter beschrieben. Erfindungsgemäß gilt grundsätzlich gilt, dass alle Komponenten mit einander kombiniert angeordnet werden können.

### Der Drehteller 20

Der Drehteller 20 ist ausgestaltet, um das zu prüfende System aufzunehmen. Der Drehteller weist hier einen Durchmesser von etwa 50cm auf und wird durch einen Motor angetrieben. Der Drehteller kann sich vorzugsweise um 360 Grad in beide Richtungen drehen. Die Geschwindigkeit, Beschleunigung und Dauer der Drehung können automatisch über ein Softwareprogramm gesteuert werden. Am Drehteller, vorzugswiese in der Mitte des Drehtellers können diverse Anschlüsse, wie USB-, LAN-, AC- und/oder DC-Anschlüsse für den Anschluss des zu messenden Systems vorgesehen sein, wodurch eine Verwickelung der Anschlüsse verhindert wird. Über Schleifkontakte und daran angeschlossenen Kabelverbindungen können diese Anschlüsse nach außen geführt werden. Die Kabelverbindungen sind hier vorzugsweise EMV-mäßig abgeschirmt.

Mit einem pneumatischen Antrieb oder einem außerhalb des Messbereiches angeordneten Motor (Elektromotor) kann der Drehteller bewegt werden, d.h. gedreht und in seiner Höhe verstellt werden. Beispielsweise kann der für den Antrieb des Drehtellers vorgesehene Elektromotor direkt unterhalb des Drehtellers im unteren Bereich U angeordnet sein.

### Die EMV-Antenne 30

Die EMV-Antenne 30 kann auf einen fest definierten Abstand zum zu messenden System, das sich auf dem Drehteller 20 befindet, eingestellt werden. Beispielsweise kann der Abstand 1 Meter betragen. Die EMV-Antenne ist beweglich ausgestaltet.

Beispielsweise kann der Abstand zum Boden des Messbereiches eingestellt werden (z.B. zwischen 10 cm und 50 cm). Zudem kann es vorgesehen sein auch den Drehwinkel um ihre vertikale Achse einzustellen (z.B. um ± 90°). Eine Drehen um eine horizontale Achse (z.B. um ± 90°) kann ebenfalls vorgesehen sein, sodass die EMV-Antenne von einer horizontalen Ausrichtung in eine vertikale Ausrichtung gebracht werden kann.

Alternativ kann eine EMV-Kamera bewegbar in dem Messbereich angeordnet sein. Bei Bedarf kann sie neu ausgerichtet werden. Um bei einer Messung mit der EMV-Antenne 30 die Messung nicht zu beeinflussen bzw. zu stören kann die EMV-Kamera weggeschwenkt oder in den unteren Teil U der Messzelle eingefahren werden.

### Der Roboterarm 40

Der Roboterarm 40 ist vorzugsweise neben dem Drehteller 20 angeordnet. Mit dem Roboterarm können Messgeräte, etwa Nahfeldsonden und/oder andere Sensoren, bei geschlossenem Deckel 10 präzise an das zu prüfende System herangeführt werden. Der Roboterarm kann per Maus über ein Softwareprogramm von außen gesteuert werden.

Zusätzlich oder alternativ zu den Nahfeldsonden und/oder Sensoren kann der Roboterarm 40 auch eine Wärmebildkamera, eine EMV-Kamera oder andere optische und/oder akustische Messwertaufnehmer aufnehmen.

Um während einer EMV-Messung die EMV-Antenne bzw. den Messvorgang nicht zu stören, kann es vorgesehen sein, den Roboterarm schwenkbar oder in den unteren Teil U der Messzelle einfahrbar auszugestalten. Alternativ kann es vorgesehen sein, den Roboterarm entfernbar auszugestalten.

### Die Wärmebildkamera

Mit der Wärmebildkamera können magnetische Felder an dem zu prüfenden Systemen sichtbar gemacht werden. Sie kann beweglich ausgestaltet sein (horizontal und/oder vertikal bewegbar und/oder drehbar), etwa mittels eines pneumatischen oder elektromotorisch angetriebenen Systems. Die eine EMV-Messung beeinflussbaren Komponenten des pneumatischen oder elektromotorisch angetriebenen Systems werden hier vorzugsweise außerhalb des Messbereiches, beispielsweise im unteren Bereich U angeordnet. Die Steuerung kann über ein Softwareprogramm erfolgen.

### Die Kameras 50

Bei der hiergezeigten Vorrichtung sind an den Ecken (vorzugsweise an den oberen Ecken) des Messbereiches Kameras 50 angeordnet, hier also insgesamt vier Kameras 50. Es können aber auch mehr oder weniger als vier Kameras vorgesehen werden. Damit können bei geschlossenem Deckel 10 die Messungen überwacht werden. Die Kameras können an eine Speichereinrichtung angeschlossen, etwa ein Videorecorder, um die von den Kameras bereitgestellten Bilder zu speichern bzw. aufzunehmen und /oder auf den Bildschirmen außen am Labor anzuzeigen. Gesteuert werden die Kameras von außen über eine entsprechende Steuersoftware. Auch diese Kameras 50 können beweglich in dem Messbereich angeordnet sein, um ihre Position und/oder Ausrichtung im Messbereich einstellen zu können.

### Die Messgeräte 70

Die Messgeräte 70 sind in dem unteren Bereich U der Box angeordnet. Vorzugsweise sind die Messgeräte lösbar in dem unteren Bereich angeordnet, sodass sie bei Bedarf entfernt oder gewechselt werden können. Als Messgeräte bzw. weitere Komponenten im unteren Bereich der Box können vorgesehen sein: Analyser, Oszilloskop, Netzteil, T-Netz Nachbildung, Antriebsvorrichtung (etwa Elektromotoren) und/oder Druckluftgeneratoren für den Antrieb der Komponenten (z.B. Drehteller 20, Roboterarm 40) in dem Messbereich, und/oder Videorecorder.

Ferner können im unteren Bereich U der Box 10 diverse Anschlüsse vorgesehen sein. Hierdurch können die Messzelle und/oder die einzelnen Geräte ein- und ausgeschaltet werden, sowie mit AC/DC und/oder LAN und/oder Druckluft versorgt werden. Außerdem ist hier ein direkter Anschluss bei geschlossenem Deckel 10 zu den Drehteller-Anschlüssen und den Steckdosen mit den diversen Anschlüssen möglich.

### Der Lüfter

Im oberen Bereich O und/oder im unteren Bereich U können ein oder mehrere Lüfter angeordnet sein, um ein Kühlen zu ermöglichen. Die Lüfter sind in den Figuren nicht gezeigt. Im oberen Bereich O ist es vorteilhaft spezielle EMV-Filterlüfter vorzusehen, die eine deutlich bessere Abschirmwirkung bzw. Dämpfung gegen elektromagnetische Felder und damit höhere EMV-Sicherheit bieten.

### Das Mikrofon

Ferner kann im Messbereich ein in den Figuren nicht gezeigtes Mikrofon vorgesehen sein. Das Mikrofon kann sich in der Nähe des Drehtellers 20 befinden. Damit können bei geschlossenem Deckel 10 die Messungen überwacht werden. Über einen Vorverstärker können die Geräusche über einen Lautsprecher nach außen übertragen werden.

### Die Beleuchtung

Im Inneren des Messbereiches kann eine Beleuchtung vorgesehen, um eine für die Kameras 50 optimale Ausleuchtung zu erreichen. In einer vorteilhaften Ausgestaltung der Erfindung kann diese Beleuchtung durch eine oder mehrere LED gebildet werden. Vorteilhaft ist die Verwendung eines sogenannten LED-Panels, das an der Decke (und gegebenenfalls an den Seitenwänden) des Messbereiches angeordnet wird. Mit einem LED-Panel wird eine Flächenbeleuchtung ermöglicht, die gleichzeitig den Schattenwurf minimiert.

### Steckdosen und weitere Anschlüsse

Ferner können im Inneren des Messbereiches Steckdosen und weitere Anschlüsse zur Strom- und Signalübertragung vorgesehen werden. Diese werden vorzugsweise so in dem Boden des Messbereiches angeordnet, dass sie eine EMV-Messung möglichst nicht beeinträchtigen. In einer Ausgestaltung der Erfindung können hierfür sogenannte Bodensteckdosen verwendet werden.

Folgende Messungen können mit der erfindungsgemäßen Vorrichtung durchgeführt werden:
1. Ohne Zusatzaufwand können alle Arten von leitungsgebundenen Messungen durchgeführt werden.
2. Ohne Zusatzaufwand können alle Arten der Radiated Emission Messungen (gestrahlte Emissionsmessungen) durchgeführt werden

Bei Vorsehen entsprechender Messgeräte kann mit der erfindungsgemäßen Vorrichtung auch eine Fehleranalyse des zu prüfenden Systems durchgeführt werden, etwa eine Fehleranalyse mit Hilfe der Wärmebildkamera oder eine Fehleranalyse durch leitungsgebundene Messungen.

### Bezugszeichenliste:

- 1: Box (EMV-Messzelle)
- 10: Deckel (aufschiebbar, aufklappbar)
- 20: Drehteller
- 30: Antenne
- 40: Roboterarm
- 50: Kameras
- 55: Wärmebildkamera
- 60: Bildschirme
- 70: Messgeräte
- M: Messkammer / Messbereich
- O: oberer Bereich der Box
- U: unterer Bereich der Box

## Patentansprüche

1. Vorrichtung (1) zur Durchführung von EMV-Test-Messungen, wobei die Vorrichtung eine als mobile Box ausgestaltete Messzelle umfasst, wobei
- die Box (1) an einer Seite eine Öffnung aufweist, die zumindest teilweise öffenbar und wieder verschließbar ist, wobei die Öffnung so ausgestaltet ist, dass durch sie hindurch zumindest ein zu prüfendes System in das Innere der Box einbringbar ist,
- das Innere der Box in zwei Bereiche, vorzugsweise in einen oberen Bereich (O) und in einen unteren Bereich (U), unterteilt ist,
- in einem der beiden Bereiche (U; Gerätebereich) Messgeräte (70) anordenbar sind und in dem jeweils anderen Bereich (O; Messbereich) das zu prüfende System anordenbar ist,
- die Unterteilung des Inneren der Box in zwei Bereiche (U; O) durch eine Platte erfolgt, wobei die Platte eine Absorberschicht und/oder eine Dämpfungsschicht und/oder eine Schirmungsschicht aufweist, um Störungen des zu prüfenden Systems durch die Messgeräte (70) und/oder Störungen der Messgeräte (70) durch das zu prüfende System weitgehend zu verhindern,
und wobei
- die Öffnung des Messbereichs (O; M) mit Klappen oder Türen (10) verschließbar ist, wobei die Klappen oder Türen eine Absorberschicht und/oder Dämpfungsschicht und/oder Schirmungsschicht aufweisen,
- in dem Messbereich (O; M) ein Drehteller (20), eine EMV-Antenne (30) und Kamerasysteme (50) angeordnet sind, wobei der Drehteller Anschlüsse für das zu prüfende System aufweist und wobei der Drehteller (20) ausgestaltet ist, das zu prüfende System aufzunehmen,
- wobei die EMV-Antenne (30) beweglich und ausrichtbar ausgestaltet ist, wobei
- die EMV-Antenne (30) auf einen fest definierten Abstand zum zu prüfenden System einstellbar ist,
- der Abstand der EMV-Antenne (30) zum Boden des Messbereiches einstellbar ist,
- Drehwinkel der EMV-Antenne (30) um ihre vertikale Achse einstellbar ist, und
- die EMV-Antenne (30) um eine horizontale Achse drehbar ist, und
- an der Außenwandung der Box zumindest eine Anzeigeeinrichtung (60) angeordnet ist, die mit den Komponenten in dem Messbereich (O; M) und/oder mit den Messgeräten (70) in dem Messbereich (U) koppelbar ist.

2. Vorrichtung nach dem vorhergehenden Anspruch, wobei in dem Messbereich (O; M) zumindest eines aus der Gruppe umfassend Roboterarm (40), Sensoren, Mikrofon, Beleuchtung, Wärmebild-Kamera, EMV-Wärmebild-Kamera, EMV-Lüfter, und Kombinationen hiervon, anordenbar sind.

3. Vorrichtung nach einem der beiden vorhergehenden Ansprüche, wobei die Messgeräte (70) lösbar in dem Gerätebereich (U) anordenbar sind, um einen einfachen und schnellen Austausch der Messgeräte zu ermöglichen.

4. Vorrichtung nach einem der beiden vorhergehenden Ansprüche, wobei die in dem Messbereich (O; M) angeordneten Komponenten lösbar in dem Messbereich angeordnet sind, um einen einfachen und schnellen Austausch der Komponenten und eine störungsfreie Messung zu ermöglichen.

5. Vorrichtung nach einem der vorhergehenden Ansprüche, wobei die Messgeräte (70) ausgewählt sind aus der Gruppe zumindest umfassend Analyser, Oszilloskop, DC-Netzteil, T-Netz Nachbildung, Videorecorder, und Kombinationen hiervon.

6. Vorrichtung nach einem der Ansprüche 2 bis 5, wobei der Roboterarm (40) so ausgestaltet ist und so relativ zum Drehteller (20) angeordnet ist, dass mit ihm zumindest ein Sensor und/oder zumindest eine Messeinrichtung relativ zum Drehteller bewegt werden kann.

7. Vorrichtung nach einem der vorhergehenden Ansprüche 2 bis 6, wobei die in dem Messbereich (O; M) angeordneten Komponenten (20; 30; 40; 50) von außerhalb der Box steuerbar sind, etwa mittels eines Joysticks, einer Maus oder einem anderen Eingabegerät.

8. Vorrichtung nach einem der vorhergehenden Ansprüche, wobei das Kamerasystem (50) zumindest eine, vorzugsweise zwei, besonders bevorzugt vier Kameras aufweist, wobei die Kameras stationär oder bewegbar in den Eckbereichen im Inneren des Messbereiches (O; M) angeordnet sind.

9. Vorrichtung nach einem der vorhergehenden Ansprüche, wobei die Seitenwände der Box aus einem Metall, insbesondere Aluminium bestehen.

10. Vorrichtung nach einem der vorhergehenden Ansprüche, wobei die Box eine maximal Abmessung von 300x240x260, vorzugsweise von 200x140x160, besonders bevorzugt von 140x60x80 (LxBxH in cm) aufweist.

11. Vorrichtung nach einem der vorhergehenden Ansprüche, wobei die Wände (Seitenwände und Decke bzw. obere Wand) des Messbereiches (O; M) eine Absorberschicht und/oder Dämpfungsschicht und/oder Schirmungsschicht aufweisen, um den Innenraum des Messbereichs von der Außenwelt abzuschirmen und Störungen eines zu prüfenden Systems zu verhindern.

12. Vorrichtung nach einem der vorhergehenden Ansprüche, wobei die Absorberschicht und/oder Dämpfungsschicht und/oder Schirmungsschicht der Platte durch eine Metallplatte gebildet wird, auf der eine Ferritfliesenschicht angebracht ist.

13. Vorrichtung nach einem der vorhergehenden Ansprüche 11 bis 12, wobei die Absorberschicht und/oder Dämpfungsschicht und/oder Schirmungsschicht der Wände eine an den Innenwänden angeordnete EMV-Folie aufweist, auf der ein vorzugsweise im Frequenzbereich zwischen 20 MHz bis 15 GHz wirksamer Polyurethan-Schaum aufgebracht ist.

14. Vorrichtung nach einem der vorhergehenden Ansprüche, wobei die in dem Messbereich (O; M) angeordneten und beweglich ausgestalteten Komponenten mittels Antriebssysteme bewegbar sind, wobei die Antriebssysteme zumindest teilweise in dem Gerätebereich (U) oder außerhalb des Messbereiches (O; M) angeordnet sind.

## Claims

1. Apparatus (1) for carrying out EMC test measurements, wherein the device comprises a measuring cell designed as a mobile box, wherein
- the box (1) has an opening on one side which can be at least partially opened and closed again, wherein the opening is designed such that at least one system to be tested can be introduced therethrough into the interior of the box,
- the inside of the box is divided into two regions, preferably an upper region (O) and a lower region (U),
- measuring devices (70) can be arranged in one of the two regions (U; device region) and the system to be tested can be arranged in the other region (O; measuring region),
- the interior of the box is divided into two regions (U; O) by a panel, wherein the panel has an absorber layer and/or an attenuation layer and/or a shielding layer in order to largely prevent interference of the system to be tested by the measuring devices (70) and/or interference of the measuring devices (70) by the system to be tested,
and wherein
- the opening of the measuring region (O; M) can be closed with flaps or doors (10), wherein the flaps or doors have an absorber layer and/or attenuation layer and/or shielding layer,
- a turntable (20), an EMC antenna (30) and camera systems (50) are arranged in the measuring region (O; M), wherein the turntable has connections for the system to be tested and wherein the turntable (20) is designed to receive the system to be tested,
- wherein the EMC antenna (30) is designed to be movable and alignable, wherein
- the EMC antenna (30) can be adjusted to a fixedly defined distance from the system to be tested,
- the distance from the EMC antenna (30) to the bottom of the measuring region can be adjusted,
- angle of rotation of the EMC antenna (30) about its vertical axis is adjustable, and
- the EMC antenna (30) can be rotated about a horizontal axis,
and
- at least one display device (60) is arranged on the outer wall of the box, which display device can be coupled to the components in the measuring region (O; M) and/or to the measuring devices (70) in the measuring region (U).

2. Apparatus according to the preceding claim, wherein at least one of the group comprising robot arm (40), sensors, microphone, lighting, thermal imaging camera, EMC thermal imaging camera, EMC fan, and combinations thereof, can be arranged in the measuring region (O; M).

3. Apparatus according to one of the two preceding claims, wherein the measuring devices (70) can be detachably arranged in the device region (U) in order to allow a simple and rapid replacement of the measuring devices.

4. Apparatus according to one of the two preceding claims, wherein the components arranged in the measuring region (O; M) are detachably arranged in the measuring region in order to allow a simple and rapid replacement of the components and an interference-free measurement.

5. Apparatus according to any of the preceding claims, wherein the measuring devices (70) are selected from the group at least comprising analyzer, oscilloscope, DC power-supply unit, T-network replica, video recorder, and combinations thereof.

6. Apparatus according to any of claims 2 to 5, wherein the robot arm (40) is designed and arranged relative to the turntable (20) such that at least one sensor and/or at least one measuring device can be moved, together with said robot arm, relative to the turntable.

7. Apparatus according to any of the preceding claims 2 to 6, wherein the components (20; 30; 40; 50) arranged in the measuring region (O; M) can be controlled from outside the box, for example by means of a joystick, a mouse or another input device.

8. Apparatus according to any of the preceding claims, wherein the camera system (50) comprises at least one, preferably two, particularly preferably four cameras, wherein the cameras are arranged so as to be stationary or movable in the corner regions in the interior of the measuring region (O; M).

9. Apparatus according to any of the preceding claims, wherein the side walls of the box consist of a metal, in particular aluminum.

10. Apparatus according to any of the preceding claims, wherein the box has a maximum dimension of 300x240x260, preferably of 200x140x160, particularly preferably of 140x60x80 (LxWxH in cm).

11. Apparatus according to any of the preceding claims, wherein the walls (side walls and top or upper wall) of the measuring region (O; M) have an absorber layer and/or attenuation layer and/or shielding layer in order to shield the interior of the measuring region from the environment and to prevent interference of a system to be tested.

12. Apparatus according to any of the preceding claims, wherein the absorber layer and/or attenuation layer and/or shielding layer of the panel is formed by a metal panel to which a ferrite tile layer is attached.

13. Apparatus according to any of the preceding claims 11 to 12, wherein the absorber layer and/or attenuation layer and/or shielding layer of the walls comprises an EMC foil arranged on the inner walls, to which foil a polyurethane foam that is preferably effective in the frequency range between 20 MHz to 15 GHz is applied.

14. Apparatus according to any of the preceding claims, wherein the components, which are arranged in the measuring region (O; M) and are designed to be movable, are movable by means of drive systems, wherein the drive systems are arranged at least partially in the device region (U) or outside the measuring region (O; M).

## Revendications

1. Dispositif (1) permettant de réaliser des mesures par test de CEM, dans lequel le dispositif comprend une cellule de mesure conçue comme une boîte mobile, dans lequel
- la boîte (1) présente sur un côté une ouverture qui peut être ouverte au moins partiellement et fermée de nouveau, dans lequel l'ouverture est conçue de sorte qu'au moins un système à tester peut être introduit à l'intérieur de la boîte à travers ladite ouverture,
- l'intérieur de la boîte est divisé en deux zones, de préférence en une zone supérieure (O) et en une zone inférieure (U),
- des appareils de mesure (70) peuvent être disposés dans l'une des deux zones (U ; zone pour appareils) et le système à tester peut être disposé dans l'autre zone (O ; zone de mesure) respective,
- la division de l'intérieur de la boîte en deux zones (U ; O) est effectuée par une plaque, dans lequel la plaque présente une couche absorbante et/ou une couche d'amortissement et/ou une couche de protection, afin d'empêcher dans une large mesure des perturbations du système à tester par les appareils de mesure (70) et/ou des perturbations des appareils de mesure (70) par le système à tester,
et dans lequel
- l'ouverture de la zone de mesure (O ; M) peut être fermée par des volets ou des portes (10), dans lequel les volets ou les portes présentent une couche absorbante et/ou une couche d'amortissement et/ou une couche de protection,
- dans la zone de mesure (O ; M) sont disposés un plateau tournant (20), une antenne CEM (30) et des systèmes de caméras (50), dans lequel le plateau tournant présente des connexions pour le système à tester et dans lequel le plateau tournant (20) est conçu pour recevoir le système à tester,
- dans lequel l'antenne CEM (30) est conçue de manière à pouvoir être déplacée et orientée, dans lequel
- l'antenne CEM (30) peut être réglée à une distance définie de manière fixe par rapport au système à tester,
- la distance de l'antenne CEM (30) par rapport au fond de la zone de mesure est réglable,
- l'angle de rotation de l'antenne CEM (30) autour de son axe vertical est réglable, et
- l'antenne CEM (30) peut tourner autour d'un axe horizontal,
et
- sur la paroi extérieure de la boîte est disposé au moins un moyen d'affichage (60) qui peut être couplé aux composants dans la zone de mesure (O ; M) et/ou aux appareils de mesure (70) dans la zone de mesure (U).

2. Dispositif selon la revendication précédente, dans lequel au moins un élément dans le groupe comprenant bras robotique (40), capteurs, microphone, éclairage, caméra thermique, caméra thermique CEM, ventilateur CEM, et des combinaisons de ceux-ci, peut être disposé dans la zone de mesure (O ; M).

3. Dispositif selon l'une des deux revendications précédentes, dans lequel les appareils de mesure (70) peuvent être disposés de manière amovible dans la zone pour appareils (U) afin de permettre un remplacement simple et rapide des appareils de mesure.

4. Dispositif selon l'une des deux revendications précédentes, dans lequel les composants disposés dans la zone de mesure (O ; M) sont disposés de manière amovible dans la zone de mesure afin de permettre un remplacement simple et rapide des composants et une mesure sans perturbation.

5. Dispositif selon l'une des revendications précédentes, dans lequel les appareils de mesure (70) sont choisis dans le groupe comprenant au moins analyseur, oscilloscope, bloc d'alimentation en courant continu, réplique de réseau en T, magnétoscope, et des combinaisons de ceux-ci.

6. Dispositif selon l'une des revendications 2 à 5, dans lequel le bras robotique (40) est conçu et disposé par rapport au plateau tournant (20) de sorte qu'au moyen dudit bras robotique, au moins un capteur et/ou au moins un moyen de mesure peuvent être déplacés par rapport au plateau tournant.

7. Dispositif selon l'une des revendications précédentes 2 à 6, dans lequel les composants (20 ; 30 ; 40 ; 50) disposés dans la zone de mesure (O ; M) peuvent être commandés depuis l'extérieur de la boîte, par exemple au moyen d'un manche à balai, d'une souris ou d'un autre appareil d'entrée.

8. Dispositif selon l'une des revendications précédentes, dans lequel le système de caméras (50) comprend au moins une, de préférence deux, de manière particulièrement préférée quatre caméras, dans lequel les caméras sont disposées de manière à être stationnaires ou de manière à pouvoir être déplacées dans les zones de coin à l'intérieur de la zone de mesure (O ; M).

9. Dispositif selon l'une des revendications précédentes, dans lequel les parois latérales de la boîte sont en un métal, en particulier en aluminium.

10. Dispositif selon l'une des revendications précédentes, dans lequel la boîte présente une dimension maximale de 300 x 240 x 260, de préférence de 200 x 140 x 160, de manière particulièrement préférée de 140 x 60 x 80 (L x I x H en cm).

11. Dispositif selon l'une des revendications précédentes, dans lequel les parois (parois latérales et plafond ou paroi supérieure) de la zone de mesure (O ; M) présentent une couche absorbante et/ou une couche d'amortissement et/ou une couche de protection, afin de protéger l'espace intérieur de la zone de mesure du monde extérieur et d'éviter des perturbations d'un système à tester.

12. Dispositif selon l'une des revendications précédentes, dans lequel la couche absorbante et/ou la couche d'amortissement et/ou la couche de protection de la plaque sont formées par une plaque métallique sur laquelle est appliquée une couche de carreaux de ferrite.

13. Dispositif selon l'une des revendications précédentes 11 à 12, dans lequel la couche absorbante et/ou la couche d'amortissement et/ou la couche de protection des parois présentent un film CEM disposé sur les parois internes, sur lequel film est appliquée une mousse de polyuréthane efficace de préférence dans la plage de fréquences comprise entre 20 MHz à 15 GHz.

14. Dispositif selon l'une des revendications précédentes, dans lequel les composants disposés dans la zone de mesure (O ; M) et conçus de manière à pouvoir être déplacés peuvent être déplacés au moyen de systèmes d'entraînement, dans lequel les systèmes d'entraînement sont disposés au moins partiellement dans la zone pour appareils (U) ou à l'extérieur de la zone de mesure (O ; M).
